# EUROPEAN PATENT APPLICATION

(11) **EP 2 290 676 A1**
(43) Date of publication of application: **02.03.2011**
(21) Application number: 09762553.7
(22) Date of filing: 12.06.2009
(51) Int. Cl.: H01L 21/52, B23K 3/06, B23K 35/26, B23K 35/30, C22C 5/02, C22C 11/06, C22C 13/00, C22C 13/02, H05K 3/34

(54) **METHOD FOR JOINING SUBSTRATE AND OBJECT TO BE MOUNTED USING SOLDER PASTE**

(30) Priority: 12.06.2008 JP 2008154003; 29.08.2008 JP 2008221633
(71) Applicant: Mitsubishi Materials Corporation, Chiyoda-ku Tokyo 100-8117 (JP)
(72) Inventor: ISHIKAWA Masayuki, Sanda-shi Hyogo 669-1339 (JP); NAKAGAWA Sho, Iwaki-shi Fukushima 971-8101 (JP)
(74) Representative: HOFFMANN EITLE
(86) International application number: PCT/JP2009/060785
(87) International publication number: WO 2009/151123

(57) **Abstract**

In this method of bonding a part to a substrate using a solder paste, the solder paste is mounted or applied between a metallization layer formed on the substrate and a metallization layer formed on the part, and the part is bonded to the substrate by performing a reflow process in a non-oxidizing atmosphere to bond the substrate and the part. The metallization layer formed on the surface of the substrate is planar and includes a metallization layer main portion that has an area smaller than that of the metallization layer of the part and a solder guide portion that protrudes from a periphery of the metallization layer main portion.

## Description

### BACKGROUND OF THE INVENTION

### Field of the Invention

The present invention relates to a method of bonding parts to a substrate using a solder paste such that the parts are disposed at the same position and are aligned in the same direction, and more particularly, to a method of bonding chips to a substrate using a Au-Sn alloy solder paste such that the chips are disposed at the same position and are aligned in the same direction.

Priority is claimed on Japanese Patent Application No. 2008-154003, filed June 12, 2008 and Japanese Patent Application No. 2008-221633, filed August 29, 2008, the content of which is incorporated herein by reference.

### Description of Related Art

In general, for example, a Au-Sn alloy solder paste has been used to bond a substrate and a semiconductor chip, such as an LED (light emitting diode) chip, a GaAs optical chip, a GaAs high-frequency chip, or a heat transfer chip. AAu-Sn alloy solder paste has been known which is obtained by mixing Au-Sn eutectic alloy gas-atomized powder having a composition including 15 mass% to 25 mass% of Sn (preferably, 20 mass% of Sn) and the balance composed of Au and inevitable impurities with a commercial flux including rosin, an activator, a solvent, and a viscosity improver.

When the Au-Sn alloy solder paste is used to bond the chip and the substrate, there are the following advantages. Since a Au-Sn alloy solder bonding layer is made of a Au-Sn solder alloy, the thermal conductivity and bonding reliability are high. Since the Au-Sn alloy solder paste is paste, it is possible to collectively supply the Au-Sn alloy solder paste to a plurality of bonding portions and collectively perform a heat treatment thereon. In addition, during a reflow process, since a flux covers the surface of the Au-Sn solder alloy, an oxide film is less likely to be formed. Therefore, the fluidity of a molten Au-Sn solder alloy is high during bonding and the wettability thereof is high. Therefore, it is possible to use the entire surface of the chip as a bonding surface. Further, it is not necessary to apply an excessive load to the chip during bonding.

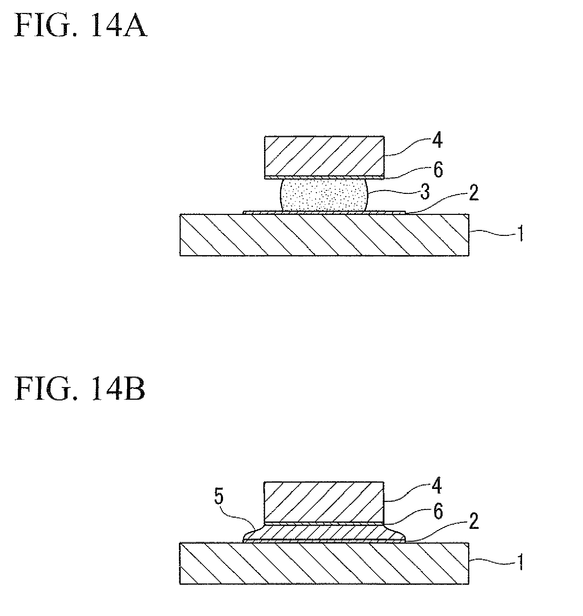

In order to bond the substrate and the chip using the Au-Sn alloy solder paste, first, as shown in a longitudinal cross-sectional view of FIG. 14A, a Au-Sn alloy solder paste 3 is mounted or applied on a metallization layer 2 formed on the surface of a substrate 1, and a chip 4 is mounted on the Au-Sn alloy solder paste 3 such that a metallization layer 6 of the chip 4 comes into contact with the Au-Sn alloy solder paste 3. In this state, when heat is applied to perform a reflow process and then a cooling process is performed, as shown in a longitudinal cross-sectional view of FIG. 14B, the substrate 1 and the chip 4 are bonded to each other with a Au-Sn alloy solder bonding layer 5 interposed therebetween (see Japanese Unexamined Patent Application, First Publication No. 2007-61857). At that time, in general, the area of the metallization layer 2 formed on the surface of the substrate 1 is equal to or more than that of the metallization layer 6 of the chip 4. In addition, in general, the chip 4 has a square shape. However, in some cases, the chip 4 has a rectangular shape.

### [Patent Citation 1]

Japanese Unexamined Patent Application, First Publication No. 2007-61857

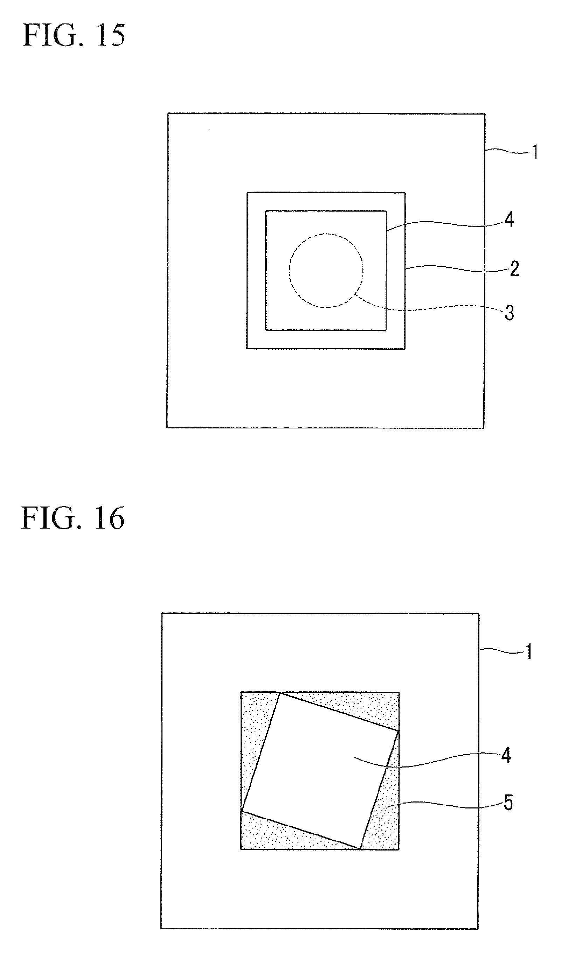

FIG. 15 is a plan view as viewed from the upper side of FIG. 14A. As shown in FIGS. 15 and 14A, the Au-Sn alloy solder paste 3 is mounted or applied to the metallization layer 2 of the substrate 1. The chip 4 is mounted on the Au-Sn alloy solder paste 3 such that the center of the chip 4 and the center of the metallization layer 2 of the substrate 1 are arranged on the same axis and in the same direction. However, when heat is applied to perform a reflow process in this state, a Au-Sn alloy solder bonding layer 5 is formed on the entire surface of the metallization layer 2 of the substrate 1 by the Au-Sn alloy solder melted in the reflow process. At the same time, the chip 4 temporarily floats on the molten Au-Sn alloy solder. In this case, the chip 4 is rotated or moved. After the cooling process, as shown in FIG. 16, which is a plan view as viewed from the upper side of FIG. 14B, in many cases, the chip 4 is soldered to the Au-Sn alloy solder bonding layer 5 on the metallization layer 2 while being inclined with respect to the metallization layer 2 of the substrate 1 so as to deviate from the center of the metallization layer 2 of the substrate 1.

In particular, in order to industrially solder the chip 4 to the substrate, a plurality of metallization layers is formed in a line on a wide substrate. A Au-Sn alloy solder paste is mounted or applied to the plurality of metallization layers and chips are regularly mounted on the Au-Sn alloy solder paste. In this state, the chips are put into a heating furnace and the chips are soldered to the substrate by one reflow process. During the reflow process, the chips are rotated and soldered to the substrate while being inclined with respect to the arranged metallization layers of the substrate so as to deviate from the central of the metallization layer in a random direction, which is not preferable as a product to be shipped. In addition, when a package size is further reduced in the future and the distance between the chips is short, the chips are likely to contact each other.

### SUMMARY OF THE INVENTION

In order to solve the above-mentioned problems and achieve an object of the present invention, the present invention uses the following methods.
(1) According a method of bonding a part to a substrate using a solder paste in a first aspect of the present invention, the method includes mounting or applying the solder paste between a metallization layer formed on the substrate and a metallization layer formed on the part, and soldering the part and the substrate by performing a reflow process in a non-oxidizing atmosphere, wherein the metallization layer formed on the surface of the substrate is planar and includes a metallization layer main portion that has an area smaller than that of the metallization layer of the part and a solder guide portion that protrudes from a periphery of the metallization layer main portion.
(2) The solder paste may be a Au-Sn alloy solder paste obtained by mixing a flux with a Au-Sn alloy solder powder including 20 mass% to 25 mass% of Sn and the balance composed of Au and inevitable impurities.
(3) The solder paste may be a Pb-Sn alloy solder paste obtained by mixing a flux with a Pb-Sn alloy solder powder including 35 mass% to 60 mass% of Pb and the balance composed of Sn and inevitable impurities.
(4) The solder paste may be a Pb-Sn alloy solder paste obtained by mixing a flux with a Pb-Sn alloy solder powder including 90 mass% to 95 mass% of Pb and the balance composed of Sn and inevitable impurities.
(5) Te solder paste may be a Pb-free solder paste obtained by mixing a flux with a Pb-free alloy solder powder including 40 mass% to 100 mass% of Sn and the balance composed of one or more kinds of metal selected from a group consisting of Ag, Au, Cu, Bi, Sb, In, and Zn and inevitable impurities.
(6) The part may be a chip.
(7) The metallization layer formed on the substrate may be an electrode film.
(8) According to a method of bonding a part to a substrate using a solder paste in a second aspect of the present invention, the method includes mounting or applying the solder paste between a metallization layer formed on the substrate and a metallization layer formed on the rectangular part, and soldering the part and the substrate by performing a reflow process in a non-oxidizing atmosphere. The metallization layer formed on the surface of the substrate is planar and includes a metallization layer main portion that has an area smaller than that of the metallization layer of the part, and at least two solder guide portions that protrude from the periphery of the metallization layer main portion, and the angle between two adjacent solder guide portions in the longitudinal direction is equal to an intersection angle between the diagonal lines of the part.
(9) The rectangular part may include a square part.
(10) According to a metallization layer formed on a surface of a substrate in a third aspect of the present invention, the metallization layer is planar and includes a metallization layer main portion and a solder guide portion protruding from the periphery of the metallization layer main portion.
(11) In the metallization layer according to (10), the metallization layer formed on the substrate may be an electrode film.
(12) According to a substrate having a metallization layer formed thereon in a fourth aspect of the present invention, the metallization layer is planar and includes a metallization layer main portion and a solder guide portion protruding from the periphery of the metallization layer main portion.
(13) In the substrate according to (12), the metallization layer may be an electrode film.
(14) According to a solder paste in a fifth aspect of the present invention, the solder paste may be a mixture of an alloy solder powder including at least Sn and a flux.
(15) According to a bonded body of a part and a substrate in a sixth aspect of the present invention, the part and the substrate are bonded by the method of bonding according to any one of (1) to (9).
(16) According to a method of producing a bonded body of a part and a substrate in a seventh aspect of the present invention, the bonded body of the part and the substrate is produced using the method of bonding according to any one of (1) to (9).

According to a method of bonding a substrate and a part in the present invention, it is possible to solder all parts at desired positions and in a desired direction.

### BRIEF DESCRIPTION OF THE DRAWINGS

FIG. 1 is a longitudinal cross-sectional view illustrating the image of the overall structure before a reflow process in a method of bonding a substrate and a chip according to the present invention.
FIG. 2A is a plan view illustrating the structure before the reflow process in the method according to the present invention.
FIG. 2B is a plan view illustrating the structure after the reflow process in the method according to the present invention.
FIG. 3A is a plan view illustrating the shape of a metallization layer formed on the substrate in the present invention.
FIG. 3B is a plan view illustrating the shape of the metallization layer formed on the substrate in the present invention.
FIG. 4A is a plan view illustrating the structure before the reflow process in the method according to the present invention.
FIG. 4B is a plan view illustrating the structure after the reflow process in the method according to the present invention.
FIG. 5A is a plan view illustrating the structure before the reflow process in the method according to the present invention.
FIG. 5B is a plan view illustrating the structure after the reflow process in the method according to the present invention.
FIG. 6 is a plan view illustrating the bonding between a metallization layer and a part according to another embodiment of the present invention.
FIG. 7 is a plan view illustrating the bonding between a metallization layer and a part according to another embodiment of the present invention.
FIG. 8 is a plan view illustrating the bonding between a metallization layer and a part according to another embodiment of the present invention.
FIG. 9 is a plan view illustrating the bonding between a metallization layer and a part according to another embodiment of the present invention.
FIG. 10 is a plan view illustrating the bonding between a metallization layer and a part according to another embodiment of the present invention.
FIG. 11 is a plan view illustrating the bonding between a metallization layer and a part according to another embodiment of the present invention.
FIG. 12 is a plan view illustrating the bonding between a metallization layer and a part according to another embodiment of the present invention.
FIG. 13 is a plan view illustrating the bonding between a metallization layer and a part according to another embodiment of the present invention.
FIG. 14A is a longitudinal cross-sectional view illustrating a structure before a reflow process in the conventional method.
FIG. 14B is a longitudinal cross-sectional view illustrating the structure after the reflow process in the conventional method.
FIG. 15 is a plan view illustrating a substrate and a chip in the state shown in FIG. 14A, as viewed from the upper side.
FIG. 16 is a plan view illustrating the substrate and the chip in the state shown in FIG. 14B, as viewed from the upper side.

### DETAILED DESCRIPTION OF THE INVENTION

The inventors have conducted a study on a bonding method capable of soldering a chip to a substrate such that the chip is constantly disposed at the same position with respect to a metallization layer of the substrate and is aligned in a given direction. As a result, it was found that the position and direction of the chip after soldering was able to be aligned in the following embodiments.

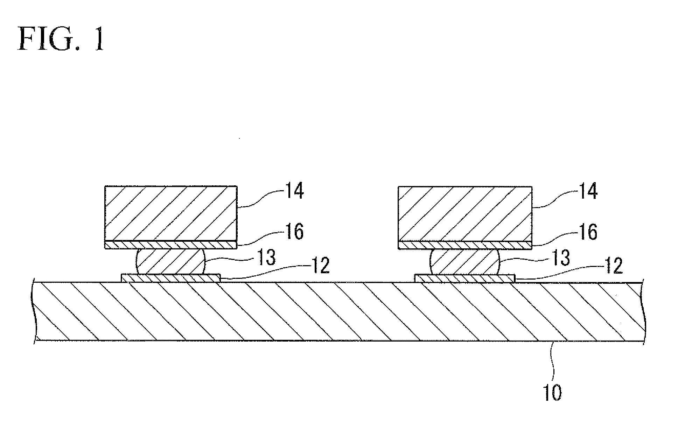

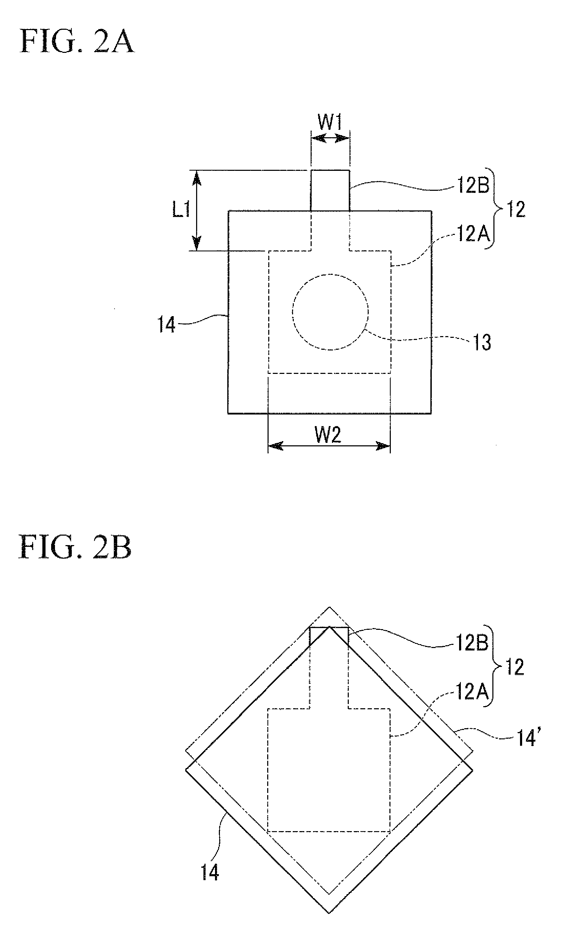

(i) As shown in a longitudinal cross-sectional view of FIG. 1, a substrate 10 and a chip 14 are bonded to each other through a metallization layer 12 of the substrate 10 and a metallization layer 16 of the chip 14 using a solder paste 13. The size of the chip 14 is not particularly limited in the present invention. However, for example, the chip 14 has one side with a length of equal to or more than 50 µm and equal to or less than 1 cm and a height of equal to or more than 10 µm and equal to or less than 5000 µm. For example, as a product, the chip 14 has one side with a length of equal to or more than 950 µm and equal to or less than 1100 µm and a height of equal to or more than 90 µm and equal to or less than 110 µm. In general, in a semiconductor chip, such as an LED (light emitting diode) chip, a GaAs optical chip, a GaAs high-frequency chip, or a heat transfer chip, a plurality of metallization layers 12 are formed on the substrate 10 at a predetermined interval. However, in the present invention, the plurality of metallization layers 12 may not be formed on the substrate 10 at a predetermined interval or one metallization layer 12 may be formed. In this embodiment, as shown in a plan view of FIG. 2A, the metallization layer 12 formed on the surface of the substrate 10 includes a metallization layer main portion 12A with a rectangular shape (a rectangular shape or a square shape) and a solder guide portion 12B that protrudes from the periphery of the metallization layer main portion 12A. In the embodiment, in particular, the thin rectangular solder guide portion 12B vertically protrudes from the center of one side of the main portion 12A. In the embodiment, the solder guide portion 12B has a constant width. However, the solder guide portion 12B may have a trapezoidal shape or a triangular shape in which it is tapered toward its leading end. It is preferable that the area of the metallization layer main portion 12A be 30% to 95% of the area of the chip 14.

The thickness of the metallization layer 12 is not particularly limited, but it is preferable that the thickness of the metallization layer 12 be, for example, equal to or more than 0.02 µm and equal to or less than 50 µm. It is more preferable that the thickness of the metallization layer 12 be, for example, equal to or more than 0.05 µm and equal to or less than 10 µm. A material forming the outermost surface of the metallization layer 12 is not particularly limited, but it is preferable that the outermost surface of the metallization layer 12 be made of, for example, Au, Ag, or Cu in terms of the wettability of solder. The metallization layer is formed by, for example, a plating method, a sputtering method, or a coating method. The width W1 of the solder guide portion 12B is not particularly limited. However, for example, the width W1 of the solder guide portion 12B is preferably in the range of 5% to 50% of the length of one side of the main portion 12A, and more preferably in the range of 10% to 40% of the length. When the width W1 is too small or too large, the effect of positioning the chip 14 is reduced. As shown in FIG. 2B, the length L1 of the solder guide portion 12B may be set such that, when the solder guide portion 12B is arranged along the diagonal line of the chip 14 with the leading end of the solder guide portion 12B aligned with the corner of the chip 14, the entire metallization layer 12 including the rear end of the metallization layer 12 is exactly concealed by the chip 14. That is, it is preferable that two corners of the rear end of the metallization layer 12 be disposed immediately below or in the vicinity of a side of the chip 14. For example, the length L1 of the solder guide portion 12B is preferably 20% to 70% of the length of one side of the metallization layer main portion 12A, and more preferably, 30% to 50% of the length within the range satisfying the above-mentioned conditions.

AAu-Sn alloy solder paste 13 is mounted on the metallization layer main portion 12A. The amount of paste 13 may be equal to that in the conventional method. Specifically, the thickness of the solder bonding layer after soldering is preferably in the range of 1 µm to 25 µm and more preferably in the range of 1 µm to 10 µm. The chip 14 with an area more than that of the metallization layer main portion 12A is mounted on the Au-Sn alloy solder paste 13 in an arbitrary direction. At that time, in the present invention, even though an accurate positioning process is not performed, it is possible to align the direction of the chip 14 after soldering using the solder guide portion 12B. Therefore, it is possible to reduce a production cost corresponding to a reduction in the positioning accuracy during assembly.

In this state, when a reflow process is performed in an inert gas atmosphere, the solder paste 13 is melted, and the chip 14 is rotated and moved to a relative position (FIG. 2B) where the overlap area between the metallization, layer 16 of the chip 14 and the metallization layer 12 of the substrate 10 is maximized by the surface tension of the molten solder. As shown in FIG. 2B, during the reflow process, the chip 14 is rotated such that the longest diagonal line (when the chip is square or rectangular, the longest diagonal line is a general diagonal line; and when the chip is elliptical, the longest diagonal line is the major axis) is aligned with the direction in which the solder guide portion 12B protrudes and is then soldered. Therefore, the direction of the solder guide portion 12B is aligned in advance, and the chips having the same shape are soldered in a given direction. In this case, the chip 14 may be moved to a portion 14' represented by a two-dot chain line. It is considered that the chip 14 is soldered in a given direction because the molten solder flows from the metallization layer main portion 12A to the solder guide portion 12B and the chip 14 is rotated.

(ii) The metallization layer main portion 12A and the solder guide portion 12B protruding from the metallization layer main portion 12A may be used as an electrode film of a semiconductor chip, such as an LED (light emitting diode) chip, a GaAs optical chip, a GaAs high-frequency chip, or a heat transfer chip.

(iii) The phenomenon shown in (i) is not limited to the substrate and the chip, but also occurs in a general part mounted on the substrate. Therefore, the present invention may be applied to a general part.

(iv) It is preferable that the solder paste be a Au-Sn alloy solder paste. However, instead of the Au-Sn alloy solder paste, the following solder paste may be used: a Pb-Sn alloy solder paste obtained by mixing a flux with Pb-Sn alloy solder powder including 35 mass% to 60 mass% of Pb and the balance composed af Sn and inevitable impurities; a Pb-Sn alloy solder paste obtained by mixing a flux with Pb-Sn alloy solder powder including 90 mass% to 95 mass% af Pb and the balance composed of Sn and inevitable impurities; or a Pb-free solder paste obtained by mixing a flux with Pb-free alloy solder powder including 40 mass% to 100 mass% of Sn and the balance composed of one or more kinds of metal selected from a group including Ag, Au, Cu, Bi, Sb, In, and Zn and inevitable impurities. In this case, the same effect as that when the Au-Sn alloy solder paste is used is obtained.

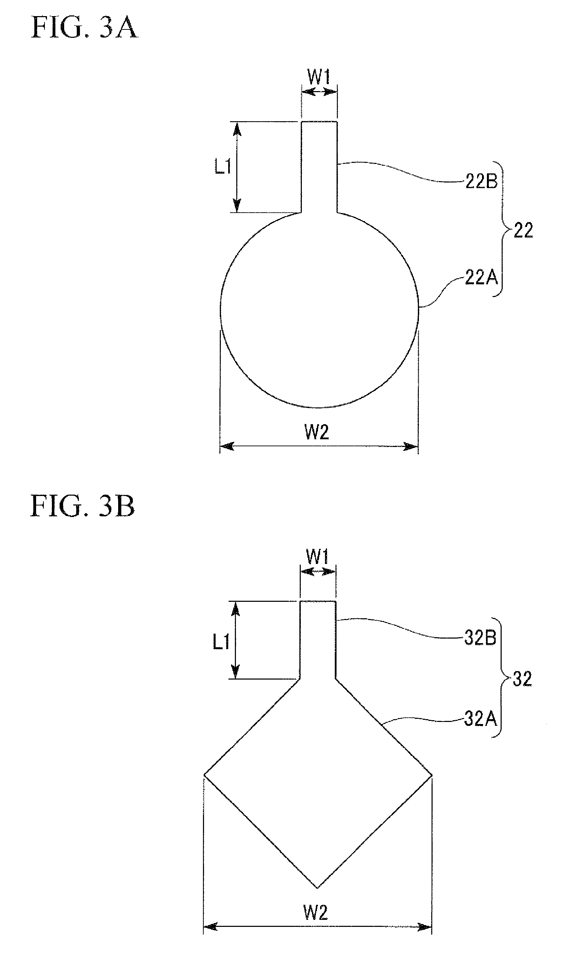

Other embodiments of the present invention are shown in FIGS. 3A to 13.

It is preferable that the shape of the metallization layer main portion formed on the substrate be the same as that of the chip, but the shape of the metallization layer main portion is not particularly limited. For example, as shown in FIG. 3A, a metallization layer 22 may include a circular metallization layer main portion 22A and a rectangular solder guide portion 22B that protrudes from the outer circumference of the circular metallization layer main portion 22A in the radius direction. The metallization layer main portion may have any planar shape other than a circular shape.

The solder guide portion may protrude from any position of the periphery of the metallization layer main portion. For example, as shown in FIG. 3B, a metallization layer 32 including a square metallization layer main portion 32A and a solder guide portion 32B that protrudes from one vertex of the metallization layer main portion 32A in the extension direction of a diagonal line may be formed.

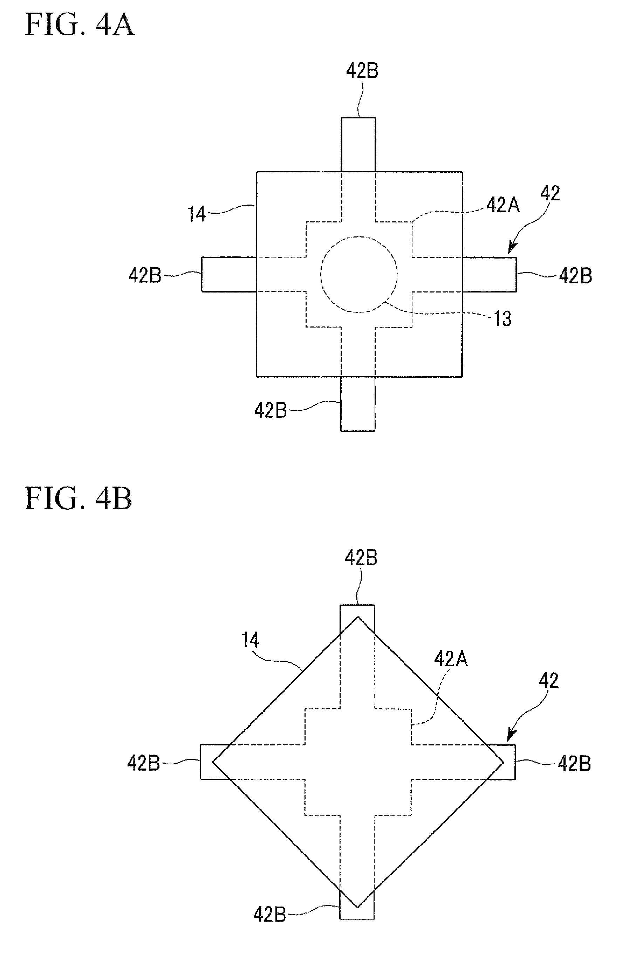

(v) FIG. 4A is a plan view illustrating still another embodiment. As shown in FIG. 4A, in this embodiment, a metallization layer 42 formed on the surface of the substrate 10 includes a square metallization layer main portion 42A and four solder guide portions 42B that vertically protrude from the centers of four sides of the metallization layer main portion 42A. The angle formed between adjacent solder guide portions 42B is 90° and equal to the angle between the diagonal lines of the chip 14 to be bonded. The Au-Sn alloy solder paste 13 is mounted on the metallization layer main portion 42A, and the square chip 14 with an area more than that of the metallization layer main portion 42A is mounted on the Au-Sn alloy solder paste 13 in an arbitrary direction. When the reflow process is performed in this state, the chip 14 is rotated such that the diagonal line of the square chip 14 is aligned with the longitudinal direction of the solder guide portion 42B by the surface tension of the molten solder and is then soldered, as shown in the plan view of FIG. 4B. As a result, all of the square chips on the substrate 10 are soldered while being aligned in a given direction. The other conditions are the same as those of the first embodiment.

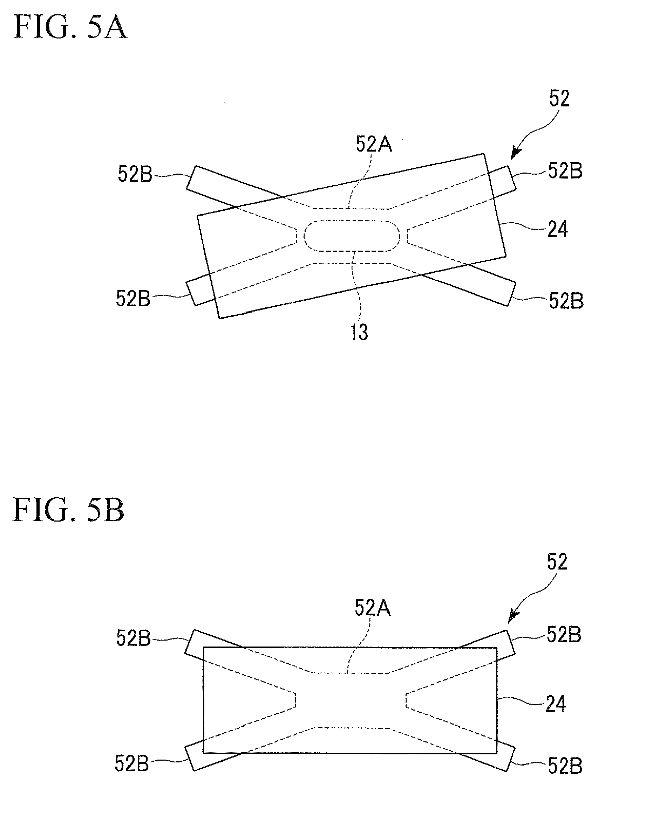

(vi) When a chip 24 with a rectangular shape is used, as shown in FIG. 5A, a metallization layer 52 including a metallization layer main portion 52A and four solder guide portions 52B that protrude from the metallization layer main portion 52A so as to intersect the diagonal lines of the rectangular chip 24 at the same angle is formed on the surface of the substrate. The Au-Sn alloy solder paste 13 is mounted on the metallization layer main portion 52A. The rectangular chip 24 is mounted on the Au-Sn alloy solder paste 13 in an arbitrary direction. When the reflow process is performed in this state, as shown in FIG. 5B, the diagonal direction of the rectangular chip 24 is aligned with the direction of the solder guide portion 52B. As a result, it is possible to solder the rectangular chip 24 in a given direction. The other conditions are the same as those of the first embodiment.

(vii) The phenomenon shown in (v) is not limited to the substrate and the square chip, but also occurs when a general square part is mounted on the substrate. In addition, the phenomenon shown in (vi) is not limited to the substrate and the rectangular chip, but also occurs when a general rectangular part is bonded to the substrate. Therefore, it is possible to apply this phenomenon to the bonding between the substrate and a square part or the bonding between the substrate and a rectangular part, thereby soldering the part to the substrate at a given position and in a given direction.

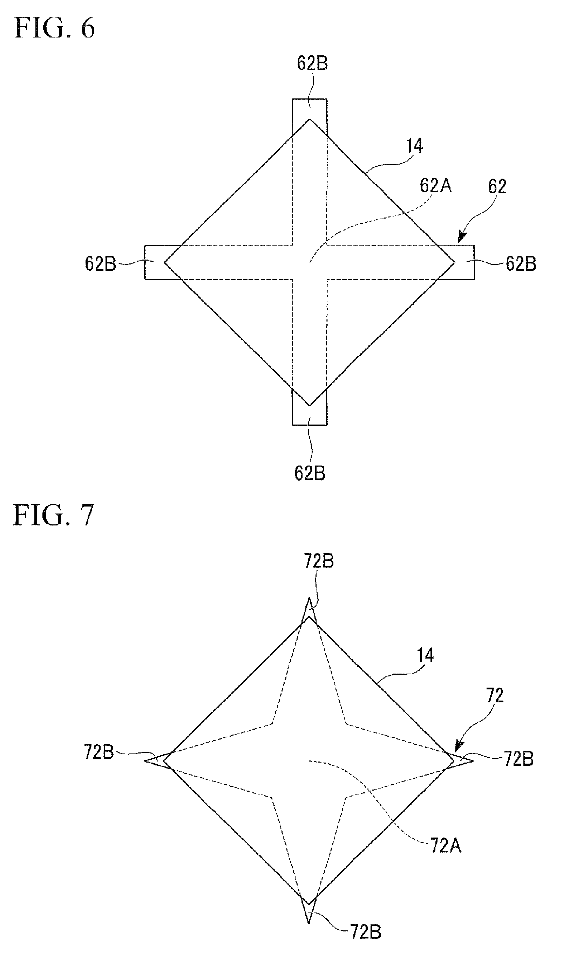

FIGS. 6 to 10 show metallization layers each having a metallization layer main portion and a plurality of solder guide portions that protrude from the periphery of the metallization layer main portion so as to intersect the diagonal lines of a square part (chip) 14 at the same angle. In order to connect the chip and the substrate, the Au-Sn alloy solder paste is mounted on the metallization layer main portion. The square part (chip) 14 with an area more than that of the metallization layer main portion is mounted on the Au-Sn alloy solder paste in an arbitrary direction. FIGS. 6 to 10 show the soldered square part (chip) 14 after the reflow process is performed in this state.

As shown in the embodiment of FIG. 6, the size of a metallization layer main portion 62A may be equal to the width of a solder guide portion 62B of a metallization layer 62. The metallization layer main portion 62A may have an area capable of mounting or applying a solder paste.

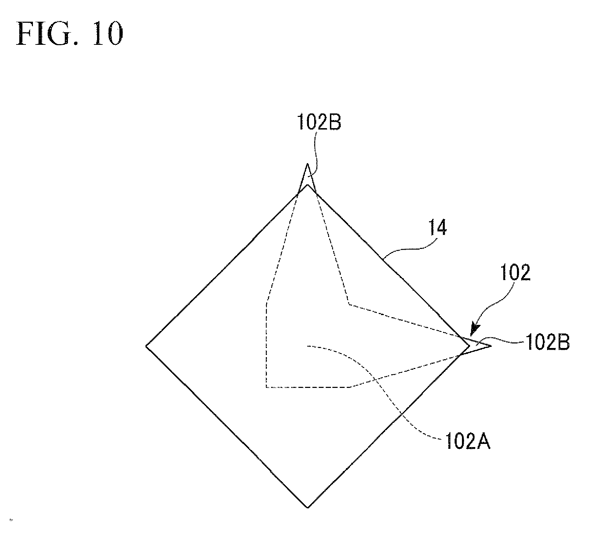

It is preferable that the solder guide portion have a strip shape with a constant width, as shown in FIG. 4B, but the shape of the solder guide portion is not limited thereto. For example, the solder guide portion may be triangular. For example, as shown in FIG. 7, a metallization layer 72 including a square metallization layer main portion 72A and triangular solder guide portions 72B that protrude from four sides of the metallization layer main portion 72A may be provided. In addition, as shown in FIG. 10, a metallization layer 102 including a square metallization layer main portion 102A and two triangular solder guide portions 102B that protrude from two adjacent sides of the metallization layer main portion 102A may be provided.

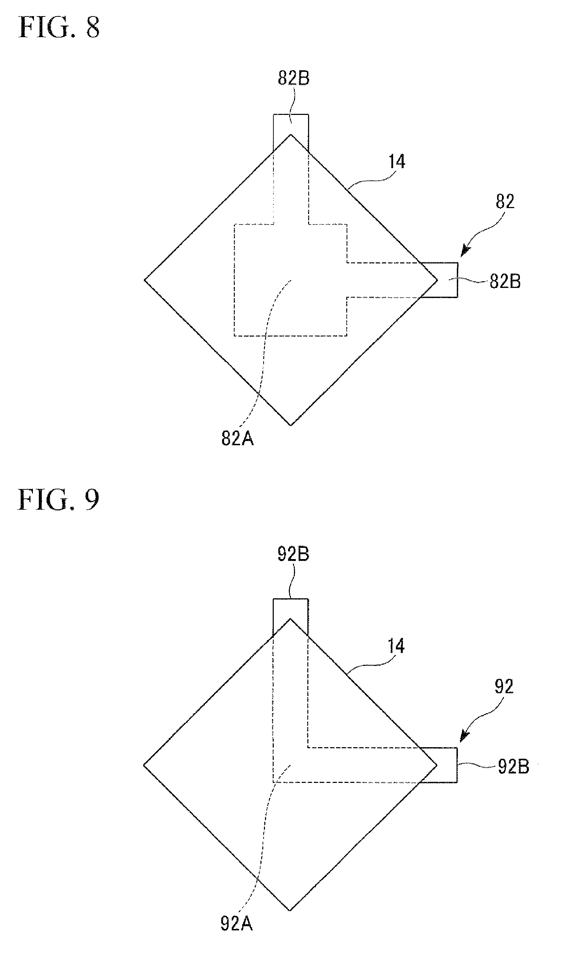

It is preferable that the number of solder guide portions be four, as shown in FIGS. 4B, 6, and 7. However, as shown in FIGS. 8 to 10, the number of solder guide portions may be two. Alternatively, the number of solder guide portions may be three or five or more. For example, as shown in FIG. 8, a metallization layer 82 including a square metallization layer main portion 82A and two solder guide portions 82B that vertically protrude from two adjacent sides of the metallization layer main portion 82A may be provided. In addition, as shown in FIG. 9, a metallization layer 92 including a square metallization layer main portion 92A and two solder guide portions 92B with a width equal to that of one side of the metallization layer main portion 92A may be provided.

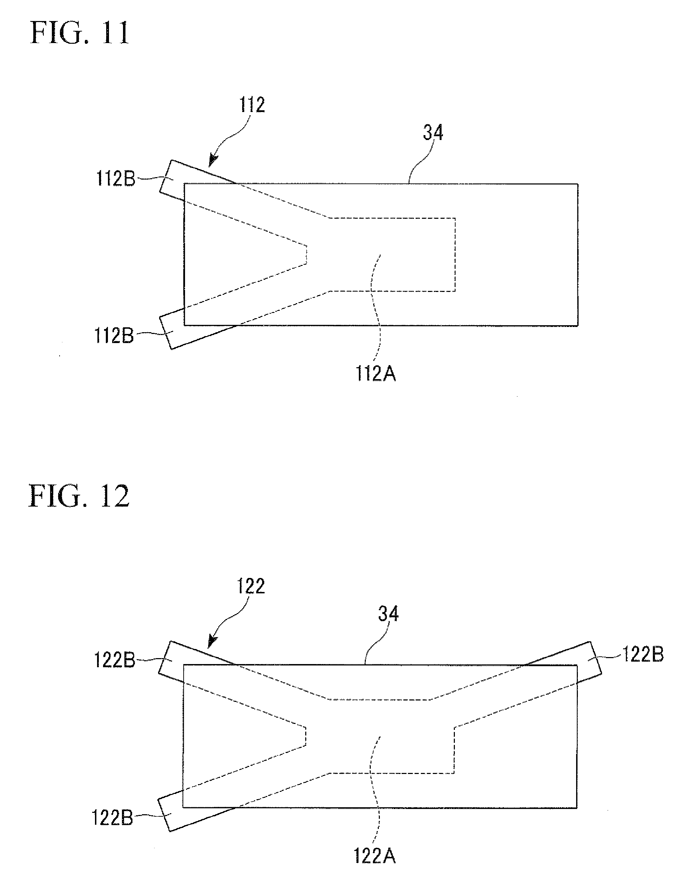

FIG. 11 shows a metallization layer including a rectangular metallization layer main portion 112A and two solder guide portions 112B that protrude from both ends of one short side of the metallization layer main portion 112A. The angle between the two solder guide portions 112B is equal to the intersection angle between two diagonal lines of a rectangular part (chip). In order to connect the chip and the substrate, the Au-Sn alloy solder paste is mounted on the metallization layer main portion 112A. A rectangular part (chip) 34 with an area more than that of the metallization layer main portion is mounted on the Au-Sn alloy solder paste in an arbitrary direction. FIG. 11 shows the soldered rectangular part (chip) 34 after the reflow process is performed in this state.

FIG. 12 shows a metallization layer including a rectangular metallization layer main portion 122A and three solder guide portions 122B that protrude from three corners of the metallization layer main portion 122A. The angle between the three solder guide portions 122B is equal to the intersection angle between two diagonal lines of the rectangular part (chip) at the corresponding positions. In order to connect the chip and the substrate, the Au-Sn alloy solder paste is mounted on the metallization layer main portion 122A. The rectangular part (chip) 34 is mounted on the Au-Sn alloy solder paste in an arbitrary direction, and the reflow process is performed. As a result, the soldering state shown in FIG. 12 is obtained.

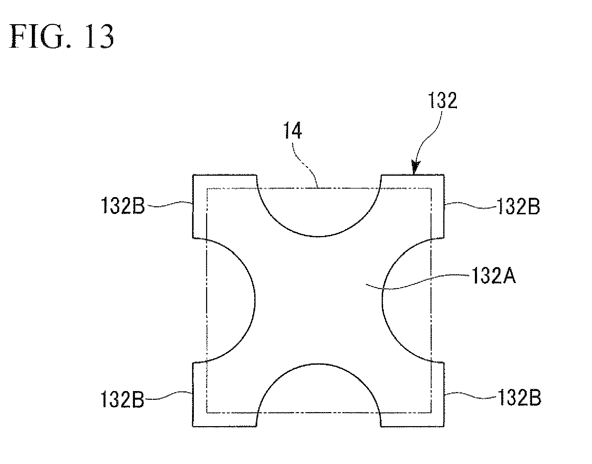

As shown is FIG. 13, the metallization layer may have a shape in which a semicircular portion is cut out from the center of each side of the square metallization layer. The metallization layer 132 includes a metallization layer main portion 132A and four solder guide portions 132B that extend from the periphery of the metallization layer main portion 132A in four directions.

### [Example 1]

Au-Sn alloy solder powder having a composition including 20 mass% of Sn and the balance composed of Au and having an average particle diameter D₅₀ of 11.1 µm and a maximum particle diameter of 20.1 µm was used as a solder alloy. A commercial RMA flux was mixed with the Au-Sn alloy solder powder such that a composition including 8.0 mass% of RMA flux and the balance composed of Au-Sn alloy solder powder was obtained, thereby producing a Au-Sn alloy solder paste with a paste viscosity of 85 Pa·s. In addition, the Au-Sn alloy solder paste was filled in a syringe and the syringe was mounted in a dispenser (model number: ML-606GX manufactured by Musashi Engineering, Inc.).

In addition, 50 LED chips each having a dimension of a length of 400 µm, a width of 400 µm, and a height of 100 µm were prepared; and a Au film having a dimension of a thickness of 3 µm, a length of 400 µm, and a width of 400 µm was formed on the entire one surface of each of the LED chips by plating.

An alumina substrate was prepared, and 50 metallization layers shown in FIG. 2A were formed in a line on the surface of the alumina substrate at an interval of 600 µm, as shown in FIG. 1. Each of the metallization layers included a metallization layer main portion, which was a composite metallization layer including a Cu layer having a dimension of a length of 200 µm, a width of 200 µm, and a thickness of 10 µm; a Ni layer having a dimension of a length of 200 µm, a width of 200 µm, and a thickness of 5 µm; and a Au layer having a dimension of a length of 200 µm, a width of 200 µm, and a thickness of 0.1 µm; and a solder guide portion having a dimension of a width of 100 µm and a length of 90 µm, which was a composite metallization layer having the same structure as that of the metallization layer main portion. The solder guide portion protruded in the direction in which the metallization layer main portions were arranged in a line.

In the 50 metallization layers each having the metallization layer main portion and the solder guide portion, 0.03 mg of Au-Sn alloy solder paste was applied onto the center of the metallization layer main portion by a previously prepared dispenser. The previously prepared 50 LED chips were mounted on the Au-Sn alloy solder paste by a mounter. In this state, a reflow process of maintaining the chips under the conditions of a nitrogen atmosphere, and a temperature of 300°C was performed for 30 seconds. Then, a cooling process was performed and the central positions of the 50 LED chips arranged in a line were measured by a three-dimensional measuring machine (NEXIV VMR-3020 manufactured by Nikon). Here, the deviation of the central positions of the bonded 50 LED chips, which were arranged in a line in the x-axis direction, in the y-axis direction was calculated as the standard deviation of the average y-axis position. As a result, it was found that the deviation of the chip central position in the y-axis direction was ±4.2 µm, and the position accuracy of the chip was very high.

### [Example 2]

Pb-Sn alloy solder powder having a composition including 37 mass% of Pb and the balance composed of Sn and having an average particle diameter D₅₀ of 11.4 µm and a maximum particle diameter of J.4.5 µm was used as a solder alloy. A commercial RMA flux was mixed with the Pb-Sn alloy solder powder such that a composition including 11.0 mass% of RMA flux and the balance composed of Pb-Sn alloy solder powder was obtained, thereby producing a Pb-Sn alloy solder paste with a paste viscosity of 120 Pa.s. In addition, the Pb-Sn alloy solder paste was filled in a syringe and the syringe was mounted in a dispenser (model number: ML-606GX manufactured by Musashi Engineering, Inc.).

The dispenser was used to apply 0.02 mg of Pb-Sn alloy solder paste onto 50 metallization layers each having the metallization layer main portion and the solder guide portion manufactured in Example 1. The previously prepared 50 LED chips were mounted on the Pb-Sn alloy solder paste. In this state, a reflow process of maintaining the chips under the conditions of a nitrogen atmosphere, and a temperature of 220°C was performed for 30 seconds. Then, a cooling process was performed and the central positions of the 50 LED chips were measured by a three-dimensional measuring machine (NEXIV VMR-3020 manufactured by Nikon). Here, the deviation of the central positions of the bonded 50 LED chips, which were arranged in a line in the x-axis direction, in the y-axis direction was calculated as the standard deviation of the average y-axis position. As a result, it was found that the deviation of the chip central position in the y-axis direction was +5.8 µm, and the position accuracy of the chip was very high.

### [Example 3]

Pb-Sn alloy solder powder having a composition including 95 mass% of Pb and the balance composed of Sn and having an average particle diameter D₅₀ of 11.7 µm and a maximum particle diameter of 14.8 µm was used as a solder alloy. A commercial RA flux was mixed with the Pb-Sn alloy solder powder such that a composition including 10.0 mass% of RA flux and the balance composed of Pb-Sn alloy solder powder was obtained, thereby producing a Pb-Sn alloy solder paste with a paste viscosity of 80 Pa.s. In addition, the Pb-Sn alloy solder paste was filled in a syringe and the syringe was mounted in a dispenser (model number: ML-606GX manufactured by Musashi Engineering, Inc.).

The dispenser was used to apply 0.03 mg of Pb-Sn alloy solder paste onto 50 metallization layers each having the metallization layer main portion and the solder guide portion manufactured in Example 1. The previously prepared 50 LED chips were mounted on the Pb-Sn alloy solder paste, and a reflow process of maintaining the chips under the conditions of a nitrogen atmosphere, and a temperature of 330°C was performed for 30 seconds. Then, a cooling process was performed and the central positions of the 50 LED chips were measured by a three-dimensional measuring machine (NEXIV VMR-3020 manufactured by Nikon). Here, the deviation of the central positions of the bonded 50 LED chips, which were arranged in a line in the x-axis direction, in the y-axis direction was calculated as the standard deviation of the average y-axis position. As a result, it was found that the deviation of the chip central position in the y-axis direction was ±6.7 µm, and the position accuracy of the chip was very high.

### [Example 4]

Pb-free solder powder having a composition including 96.5 mass% of Sn, 3.0 mass% of Ag, and the balance composed of Cu and having an average particle diameter D₅₀ of 10.8 µm and a maximum particle diameter of 14.1 µm was used as a solder alloy. A commercial RMA flux was mixed with the Pb-free solder powder such that a composition including 12.5 mass% of RMA flux and the balance composed of Pb-free solder powder was obtained, thereby producing a Pb-free solder paste with a paste viscosity of 72 Pa·s. In addition, the Pb-free solder paste was filled in a syringe and the syringe was mounted in a dispenser (model number: ML-606GX manufactured by Musashi Engineering, Inc.).

The dispenser was used to apply 0.02 mg of Pb-free solder paste onto 50 metallization layers each having the metallization layer main portion and the solder guide portion manufactured in Example 1. The previously prepared 50 LED chips were mounted on the Pb-free solder paste, and a reflow process of maintaining the chips under the conditions of a nitrogen atmosphere, and a temperature of 240°C was performed for 30 seconds. Then, a cooling process was performed and the central positions of the 50 LED chips were measured by a three-dimensional measuring machine (NEXIV VMR-3020 manufactured by Nikon). Here, the deviation of the central positions of the bonded 50 LED chips, which were arranged in a line in the x-axis direction, in the y-axis direction was calculated as the standard deviation of the average y-axis position. As a result, it was found that the deviation of the chip central position in the y-axis direction was ±5.1 µm, and the position accuracy of the chip was very high.

### (Conventional example 1)

Au-Sn alloy solder powder having a composition including 20 mass% of Sn and the balance composed of Au and having an average particle diameter D₅₀ of 11.1 µm and a maximum particle diameter of 20.1 µm was used as a solder alloy. A commercial RMA flux was mixed with the Au-Sn alloy solder powder such that a composition including 8.0 mass% of RMA flux and the balance of Au-Sn alloy solder powder was obtained, thereby producing a Au-Sn alloy solder paste with a paste viscosity of 85 Pa·s. In addition, the Au-Sn alloy solder paste was filled in a syringe and the syringe was mounted in a dispenser (model number: ML-606GX manufactured by Musashi Engineering, Inc.).

In addition, 50 LED chips each having a dimension of a length of 400 µm, a width of 400 µm, and a height of 100 µm were prepared; and aAu film having a dimension of a thickness of 3 µm, a length of 400 µm, and a width of 400 µm was formed on entire one surface of each of the LED chips by plating.

An alumina substrate was prepared, and 50 metallization layers shown in FIG. 15, which were composite metallization layers each including a Cu layer having a dimension of a length of 500 µm, a width of 500 µm, and a thickness of 10 µm; a Ni layer having a dimension of a length of 500 µm, a width of 500 µm, and a thickness of 5 µm; and a Au layer having a dimension of a length of 500 µm, a width of 500 µm, and a thickness of 0.1 µm; were formed in a line on the surface of the alumina substrate at an interval of 600 µm.

0.03 mg of Au-Sn alloy solder paste was applied onto the center of each of the 50 metallization layers, which were the composite metallization layers, by a previously prepared dispenser. The previously prepared 50 LED chips were mounted on the Au-Sn alloy solder paste by a mounter. In this state, a reflow process of maintaining the chips under the conditions of a nitrogen atmosphere, and a temperature of 300°C was performed for 30 seconds. Then, a cooling process was performed and the central positions of the 50 LED chips arranged in a line were measured by a three-dimensional measuring machine (NEXIV VMR-3020 manufactured by Nikon). Here, the deviation of the central positions of the bonded 50 LED chips, which were arranged in a line in the x-axis direction, in the y-axis direction was calculated as the standard deviation of the average y-axis position. As a result, it was found that the deviation of the chip central position in the y-axis direction was +38.2 µm, and the position accuracy of the chip was low.

### [Example 5]

Au-Sn alloy solder powder having a composition including 20 mass% of Sn and the balance composed of Au and having an average particle diameter D₅₀ of 11.1 µm and a maximum particle diameter of 20.1 µm was used as a solder alloy. A commercial RMA flux was mixed with the Au-Sn alloy solder powder such that a composition including 8.0 mass% of RMA flux and the balance composed of Au-Sn alloy solder powder was obtained, thereby producing a Au-Sn alloy solder paste with a paste viscosity of 85 Pa·s. In addition, the Au-Sn alloy solder paste was filled in a syringe and the syringe was mounted in a dispenser (model number: ML-606GX manufactured by Musashi Engineering, Inc.).

In addition, 50 square LED chips each having a dimension of a length of 400 µm, a width of 400 µm, and a height of 100 µm were prepared; and a Au film having a dimension of a thickness of 3 µm, a length of 400 µm, and a width of 400 µm was formed on the entire one surface of each of the LED chips by plating.
An alumina substrate was prepared, and 50 metallization layers having a planar shape shown in FIG. 4B were formed in a line on the surface of the alumina substrate at an interval of 600 µm. Each of the metallization layers included a metallization layer main portion, which was a composite metallization layer including a Cu layer having a dimension of a length of 200 µm, a width of 200 µm, and a thickness of 10 µm; a Ni layer having a dimension of a length of 200 µm, a width of 200 µm, and a thickness of 5 µm; and a Au layer having a dimension of a length of 200 µm, a width of 200 µm, and a thickness of 0.1 µm; and a solder guide portion that protruded from the metallization layer main portion in a cross shape and had a dimension of a width of 50 µm and a length of 150 µm, which was a composite metallization layer having the same structure as the metallization layer main portion.

In the 50 metallization layers each having the metallization layer main portion and the solder guide portion, 0.03 mg of Au-Sn alloy solder paste was applied onto the center of the metallization layer main portion by a previously prepared dispenser. The previously prepared 50 LED chips were mounted on the Au-Sn alloy solder paste by a mounter. In this state, a reflow process of maintaining the chips under the conditions of a nitrogen atmosphere, and a temperature of 300°C was performed for 30 seconds. Then, a cooling process was performed and the central positions of the 50 LED chips arranged in a line were measured by a three-dimensional measuring machine (NEXIV VMR-3020 manufactured by Nikon). Here, the deviations of the central positions of the bonded 50 LED chips in the y-axis direction and the x-axis direction were calculated as the standard deviation of the average y-axis position and the standard deviation of the average x-axis position, respectively. As a result, it was found that the deviation of the chip central position in the x-axis direction was ±4.8 µm, and the deviation of the chip central position in the y-axis direction was ±5.2 µm. Accordingly, the position accuracy of the chip was very high.

### [Example 6]

Pb-Sn alloy solder powder having a composition including 37 mass% of Pb and the balance composed of Sn and having an average particle diameter D₅₀ of 11.4 µm and a maximum particle diameter of 14.5 µm was used as a solder alloy. A commercial RMA flux was mixed with the Pb-Sn alloy solder powder such that a composition including 11.0 mass% of RMA flux and the balance composed of Pb-Sn alloy solder powder was obtained, thereby producing a Pb-Sn alloy solder paste with a paste viscosity of 120 Pa.s. The Pb-Sn alloy solder paste was filled in a syringe and the syringe was mounted in a dispenser (model number: ML-606GX manufactured by Musashi Engineering, Inc.).

In addition, 50 rectangular LED chips each having a dimension of a length of 200 µm, a width of 400 µm, and a height of 100 µm were prepared; and a Au film having a dimension of a thickness of 3 µm, a length of 200 µm, and a width of 400 µm was formed on the entire one surface of each of the LED chips by plating.

An alumina substrate was prepared, and 50 metallization layers having a planar shape shown in FIG. 5B were formed in a line on the surface of the alumina substrate at an interval of 600 µm. Each of the metallization layers included a metallization layer main portion, which was a composite metallization layer including a Cu layer having a dimension of a length of 100 µm, a width of 200 µm, and a thickness of 10 µm; a Ni layer having a dimension of a length of 100 µm, a width of 200 µm, and a thickness of 5 µm; and a Au layer having a dimension of a length of 100 µm, a width of 200 µm, and a thickness of 0.1 µm; and four solder guide portions that protruded from the metallization layer main portion at the same angle as the diagonal line of the rectangular LED chip and had a dimension of a width of 50 µm and a length of 150 µm, which were a composite metallization layer having the same structure as the metallization layer main portion.

In the 50 metallization layers each having the metallization layer main portion and the solder guide portion, 0.02 mg of Pb-Sn alloy solder paste was applied onto the center of the metallization layer main portion by a previously prepared dispenser. The previously prepared 50 LED chips were mounted on the Pb-Sn alloy solder paste by a mounter. In this state, a reflow process of maintaining the chips under the conditions of a nitrogen atmosphere, and a temperature of 220°C was performed for 30 seconds. Then, a cooling process was performed and the central positions of the 50 LED chips arranged in a line were measured by a three-dimensional measuring machine (NEXIV VMR-3020 manufactured by Nikon). Here, the deviations of the central positions of the bonded 50 LED chips in the x-axis direction and the y-axis direction were calculated as the standard deviation of the average x-axis position and the standard deviation of the average y-axis position, respectively. As a result, it was found that the deviation of the chip central position in the x-axis direction was ±7.1 µm, and the deviation of the chip central position in the y-axis direction was ±6.8 µm. Accordingly, the position accuracy of the chip was very high.

### [Example 7]

Pb-Sn alloy solder powder having a composition including 95 mass% of Pb and the balance composed of Sn and having an average particle diameter D₅₀ of 11.7 µm and a maximum particle diameter of 14.8 µm was used as a solder alloy. A commercial RA flux was mixed with the Pb-Sn alloy solder powder such that a composition including 10.0 mass% of RA flux and the balance composed of Pb-Sn alloy solder powder was obtained, thereby producing a Pb-Sn alloy solder paste with a paste viscosity of 80 Pa·s. The Pb-Sn alloy solder paste was filled in a syringe and the syringe was mounted in a dispenser (model number: ML-606GX manufactured by Musashi Engineering, Inc.).

In addition, 50 rectangular LED chips each having a dimension of a length of 200 µm, a width of 400 µm, and a height of 100 µm were prepared; and a Au film having a dimension of a thickness of 3 µm, a length of 200 µm, and a width of 400 µm was formed on the entire one surface of each of the LED chips by plating.

An alumina substrate was prepared, and 50 metallization layers having the planar shape shown in FIG. 11 were formed in a line on the surface of the alumina substrate at an interval of 600 µm. Each of the metallization layers included a metallization layer main portion, which was a composite metallization layer including a Cu layer having a dimension of a length of 100 µm, a width of 200 µm, and a thickness of 10 µm; a Ni layer having a dimension of a length of 100 µm, a width of 200 µm, and a thickness of 5 µm; and a Au layer having a dimension of a length of 100 µm, a width of 200 µm, and a thickness of 0.1 µm; and two solder guide portions that protruded from the metallization layer main portion at the same angle as the diagonal line of the rectangular LED chip and had a dimension of a width of 100 µm and a length of 150 µm, which were a composite metallization layer having the same structure as the metallization layer main portion.

In the 50 metallization layers each having the metallization layer main portion and the solder guide portion, 0.03 mg of Pb-Sn alloy solder paste was applied onto the center of the metallization layer main portion by a previously prepared dispenser. The previously prepared 50 LED chips were mounted on the Pb-Sn alloy solder paste by a mounter. In this state, a reflow process of maintaining the chips under the conditions of a nitrogen atmosphere, and a temperature of 330°C was performed for 30 seconds. Then, a cooling process was performed and the central positions of the 50 LED chips arranged in a line were measured by a three-dimensional measuring machine (NEXIV VMR-3020 manufactured by Nikon). Here, the deviations of the central positions of the bonded 50 LED chips in the x-axis direction and the y-axis direction were calculated as the standard deviation of the average x-axis position and the standard deviation of the average y-axis position, respectively. As a result, it was found that the deviation of the chip central position in the x-axis direction was ±6.6 µm, and the deviation of the chip central position in the y-axis direction was ±7.2 µm. Accordingly, the position accuracy of the chip was very high.

### [Example 8]

Pb-free solder powder having a composition including 96.5 mass% of Sn, 3.0 mass% of Ag, and the balance composed of Cu and having an average particle diameter D₅₀ of 10.8 µm and a maximum particle diameter of 14.1 µm was used as a solder alloy. A commercial RMA flux was mixed with the Pb-free solder powder such that a composition including 12.5 mass% of RMA flux and the balance composed of Pb-free solder powder was obtained, thereby producing a Pb-free solder paste with a paste viscosity of 72 Pa·s. The Pb-free solder paste was filled in a syringe and the syringe was mounted in a dispenser (model number: ML-606GX manufactured by Musashi Engineering, Inc.).

In addition, 50 square LED chips each having a dimension of a length of 400 µm, a width of 400 µm, and a height of 100 µm were prepared; and a Au film having a dimension of a thickness of 3 µm, a length of 400 µm, and a width of 400 µm was formed on the entire one surface of each of the LED chips by plating.
An alumina substrate was prepared, and 50 metallization layers having the planar shape shown in FIG. 8 were formed in a line on the surface of the alumina substrate at an interval of 600 µm. Each of the metallization layers included a metallization layer main portion, which was a composite metallization layer including a Cu layer having a dimension of a length of 200 µm, a width of 200 µm, and a thickness of 10 µm; a Ni layer having a dimension of a length of 200 µm, a width of 200 µm, and a thickness of 5 µm; and a Au layer having a dimension of a length of 200 µm, a width of 200 µm, and a thickness of 0.1 µm; and two solder guide portions that protruded from the metallization layer main portion in an L shape and had a dimension of a width of 100 µm and a length of 200 µm, which were a composite metallization layer having the same structure as the metallization layer main portion.

In the 50 metallization layers each having the metallization layer main portion and the solder guide portion, 0.02 mg of Pb-free solder paste was applied onto the center of the metallization layer main portion by a previously prepared dispenser. The previously prepared 50 LED chips were mounted on the Pb-free solder paste by a mounter. In this state, a reflow process of maintaining the chips under the conditions of a nitrogen atmosphere, and a temperature of 240°C was performed for 30 seconds. Then, a cooling process was performed and the central positions of the 50 LED chips arranged in a line were measured by a three-dimensional measuring machine (NEXIV VMR-3020 manufactured by Nikon). Here, the deviations of the central positions of the bonded 50 LED chips in the x-axis direction and the y-axis direction were calculated as the standard deviation of the average x-axis position and the standard deviation of the average y-axis position, respectively. As a result, it was found that the deviation of the chip central position in the x-axis direction was ±9.3 µm, and the deviation of the chip central position in the y-axis direction was ±8.9 µm. Accordingly, the position accuracy of the chip was very high.

### (Conventional example 2)

Au-Sn alloy solder powder having a composition including 20 mass% of Sn and the balance composed of Au and having an average particle diameter D₅₀ of 11.1 µm and a maximum particle diameter of 20.1 µm was used as a solder alloy. A commercial RMA flux was mixed with the Au-Sn alloy solder powder such that a composition including 8.0 mass% of RMA flux and the balance composed of Au-Sn alloy solder powder was obtained, thereby producing aAu-Sn alloy solder paste with a paste viscosity of 85 Pa·s. In addition, the Au-Sn alloy solder paste was filled in a syringe and the syringe was mounted in a dispenser (model number: ML-606GX manufactured by Musashi Engineering, Inc.).

In addition, 50 LED chips each having a dimension of a length of 400 µm, a width of 400 µm, and a height of 100 µm were prepared; and a Au film having a dimension of a thickness of 3 µm, a length of 400 µm, and a width of 400 µm was formed on the entire one surface of each of the LED chips by plating.

An alumina substrate was prepared, and 50 metallization layers, which were composite metallization layers each including a Cu layer having a dimension of a length of 500 µm, a width of 500 µm, and a thickness of 10 µm; a Ni layer having a dimension of a length of 500 µm, a width of 500 µm, and a thickness of 5 µm; and a Au layer having a dimension of a length of 500 µm, a width of 500 µm, and a thickness of 0.1 µm were formed in a line on the surface of the alumina substrate at an interval of 600 µm.

0.03 mg ofAu-Sn alloy solder paste was applied onto the center of each of the 50 metallization layers, which were the composite metallization layers, by a previously prepared dispenser. The previously prepared 50 LED chips were mounted on the Au-Sn alloy solder paste by a mounter. In this state, a reflow process of maintaining the chips under the conditions of a nitrogen atmosphere, and a temperature of 300°C was performed for 30 seconds. Then, a cooling process was performed and the central positions of the 50 LED chips arranged in a line were measured by a three-dimensional measuring machine (NEXIV VMR-3020 manufactured by Nikon). Here, the deviations of the central positions of the bonded 50 LED chips, which were arranged in a line in the x-axis direction, in the x-axis direction and the y-axis direction was calculated as the standard deviation of the average x-axis position and the standard deviation of the average y-axis position, respectively. As a result, it was found that the deviation of the chip central position in the x-axis direction was ±42.1 µm, and the deviation of the chip central position in the y-axis direction was ±37.5 µm. Accordingly, the position accuracy of the chip was low.

While preferred embodiments of the invention have been described and illustrated above, it should be understood that these are exemplary of the invention and are not to be considered as limiting. Additions, omissions, substitutions, and other modifications can be made without departing from the scope of the present invention. Accordingly, the invention is not to be considered as being limited by the foregoing description, and is only limited by the scope of the appended claims.

The present invention provides a method of bonding parts to a substrate using solder paste such that the parts are disposed at the same position and are aligned in the same direction, particularly, a method of bonding chips to a substrate using a Au-Sn alloy solder paste such that the chips are disposed at the same position and are aligned in the same direction. Therefore, the present invention has industrial applicability.

### [Reference Symbol List]

- 1:: SUBSTRATE
- 2:: METALLIZATION LAYER
- 3:: Au-Sn ALLOY SOLDER PASTE
- 4:: CHIP, PART
- 5:: Au-Sn ALLOY SOLDER BONDING LAYER
- 6:: METALLIZATION LAYER
- 10:: SUBSTRATE
- 12:: METALLIZATION LAYER
- 12A:: METALLIZATION LAYER MAIN PORTION
- 12B:: SOLDER GUIDE PORTION
- 13:: Au-Sn ALLOY SOLDER PASTE
- 14:: SQUARE CHIP OR SQUARE PART
- 16:: METALLIZATION LAYER
- 24:: RECTANGULAR CHIP OR RECTANGULAR PART
- 42:: METALLIZATION LAYER
- 42A:: METALLIZATION LAYER MAIN PORTION
- 42B:: SOLDER GUIDE PORTION
- 52:: METALLIZATION LAYER
- 52A:: METALLIZATION LAYER MAIN PORTION
- 52B:: SOLDER GUIDE PORTION

## Claims

1. A method of bonding a part to a substrate using a solder paste, the method comprising:
mounting or applying the solder paste between a metallization layer formed on the substrate and a metallization layer formed on the part; and
soldering the part and the substrate by performing a reflow process in a non-oxidizing atmosphere to melt a solder,
wherein the metallization layer formed on the substrate is planar and includes a metallization layer main portion that has an area smaller than that of the metallization layer of the part, and a solder guide portion that protrudes from a periphery of the metallization layer main portion.

2. The method of bonding the part to the substrate using the solder paste according to claim 1,
wherein the solder paste is a Au-Sn alloy solder paste obtained by mixing a flux with a Au-Sn alloy solder powder including 20 mass% to 25 mass% of Sn and a balance composed of Au and inevitable impurities.

3. The method of bonding the part to the substrate using the solder paste according to claim 1,
wherein the solder paste is a Pb-Sn alloy solder paste obtained by mixing a flux with a Pb-Sn alloy solder powder including 35 mass% to 60 mass% of Pb and a balance composed of Sn and inevitable impurities.

4. The method of bonding the part to the substrate using the solder paste according to claim 1,
wherein the solder paste is a Pb-Sn alloy solder paste obtained by mixing a flux with a Pb-Sn alloy solder powder including 90 mass% to 95 mass% ofPb and a balance composed of Sn and inevitable impurities.

5. The method of bonding the part to the substrate using the solder paste according to claim 1,
wherein the solder paste is a Pb-free solder paste obtained by mixing a flux with a Pb-free alloy solder powder including 40 mass% to 100 mass% of Sn and a balance composed of one or more kinds of metal selected from a group consisting of Ag, Au, Cu, Bi, Sb, In, and Zn and inevitable impurities.

6. The method of bonding the part to the substrate using the solder paste according to claim 1,
wherein the part is a chip.

7. The method of bonding the part to the substrate using the solder paste according to claim 1,
wherein the metallization layer formed on the substrate is an electrode film.

8. The method of bonding the part to the substrate using the solder paste according to claim 1,
wherein the metallization layer formed on a surface of the substrate is planar and includes at least two solder guide portions protruding from the periphery of the metallization layer main portions, and
an angle between two adjacent solder guide portions in a longitudinal direction is equal to an intersection angle between the diagonal lines of the part.

9. A metallization layer formed on a surface of a substrate comprising:
a metallization layer main portion; and
a solder guide portion protruding from a periphery of the metallization layer main portion,
wherein the metallization layer is planar.

10. The metallization layer formed on the surface of the substrate according to claim 9,
wherein the metallization layer formed on the substrate is an electrode film.

11. A substrate having a metallization layer formed thereon,
wherein the metallization layer is planar and includes a metallization layer main portion and a solder guide portion protruding from the metallization layer main portion.

12. The substrate according to claim 11,
wherein the metallization layer formed on the substrate is an electrode film.

13. A bonded body of a part and a substrate obtained by the method of bonding according to claim 1.

14. A method of producing a bonded body of a part and a substrate using the method of bonding according to claim 1.
